(19) Europäisches Patentamt
European Patent Office
Office européen des brevets

(11) EP 1 574 847 B1

(12) **EUROPÄISCHE PATENTSCHRIFT**

(45) Veröffentlichungstag und Bekanntmachung des Hinweises auf die Patenterteilung:
**18.06.2008 Patentblatt 2008/25**

(51) Int Cl.:
***G01N 27/22*** *(2006.01)*

(21) Anmeldenummer: **05000783.0**

(22) Anmeldetag: **15.01.2005**

(54) **Schaltungsanordnung zur kapazitiven Feuchtemessung und Verfahren zum Betrieb derselben**

Circuit for measuring moisture capacitively and method for using the same

Circuit pour la mesure capacitive de l'humidité et méthode pour son utilisation.

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **06.02.2004 DE 102004006020**

(43) Veröffentlichungstag der Anmeldung:
**14.09.2005 Patentblatt 2005/37**

(73) Patentinhaber: **E+E Elektronik Ges.m.b.H.
4210 Engerwitzdorf (AT)**

(72) Erfinder: **Haider, Albin
4020 Linz (AT)**

(74) Vertreter: **Hofmann, Ernst
Dr. Johannes Heidenhain GmbH,
Patentabteilung,
Postfach 12 60
83292 Traunreut (DE)**

(56) Entgegenhaltungen:
EP-A- 1 341 306          DE-A1- 19 701 899
US-A1- 2003 010 119          US-B1- 6 466 036

• DIETZ P H ET AL: "Wireless liquid level sensing for restaurant applications" PROCEEDINGS OF IEEE SENSORS 2002. ORLANDO, FL, JUNE 12 - 14, 2002, IEEE INTERNATIONAL CONFERENCE ON SENSORS, NEW YORK, NY : IEEE, US, Bd. VOL. 1 OF 2. CONF. 1, 12. Juni 2002 (2002-06-12), Seiten 715-720, XP010605190 ISBN: 0-7803-7454-1

## Beschreibung

Die vorliegende Erfindung betrifft eine Schaltungsanordnung zur kapazitiven Feuchtemessung sowie ein Verfahren zum Betrieb derselben.

In vielfältigen Applikationen ergibt sich heutzutage die Anforderung, bestimmte Umgebungsbedingungen genau zu überwachen und ggf. innerhalb einer vorgegebenen Bandbreite zu regeln. Dies kann beispielsweise in modernen Fertigungsprozessen, in der Klimatisierungstechnik, im Kfz-Bereich oder aber in Haushaltsgeräten der Fall sein. Neben der Überwachung und Regelung der Temperatur als wichtiger Umgebungsparameter muss in zunehmendem Maße auch die Umgebungsfeuchte überwacht und ggf. geregelt werden.

Auf der Sensorseite werden zur Messung der relativen Feuchte häufig kapazitive Feuchtesensoren verwendet, die zumeist in Dünnschichttechnik gefertigt sind. Kapazitive Feuchtesensoren bestehen üblicherweise aus zwei gegenüberliegenden flächigen Metallelektroden, zwischen denen ein hygroskopisches Material, üblicherweise ein Polymer, angeordnet ist. Das Polymer besitzt eine feuchteabhängige Dielektrizitätskonstante, so dass messtechnisch letztlich ein Plattenkondensator resultiert, dessen Kapazität sich in Abhängigkeit von der relativen Umgebungsfeuchte ändert. Als Messgröße für die relative Feuchte fungiert demzufolge die jeweils aktuelle Kapazität des Feuchtesensors. Zur Kapazitätsmessung sind in kapazitiven Feuchtesensoren verschiedene Messverfahren gebräuchlich.

Beispielsweise ist aus der DE 41 03 433 A1 bekannt, die Kapazitätsmessung auf eine Frequenzmessung in einem LC- oder RC- Schwingkreis zurückzuführen, wobei sich die gemessene Frequenz wiederum in Abhängigkeit der Schwingkreis-Kapazität und damit abhängig von der relativen Feuchte ändert. Neben der Vielzahl erforderlicher Bauelemente zum Aufbau des jeweiligen Schwingkreises ist als nachteilig an dieser Variante anzuführen, dass diese auch einen entsprechend hohen Stromverbrauch zur Folge haben. Hinzu kommt, dass zur exakten Frequenzmessung eine stabile Zeitbasis erforderlich ist, die sich auch unter schwankenden Umgebungsbedingungen und im Verlauf der Betriebszeit nicht ändert. Diese Anforderungen lassen sich nicht auf einfache Art und Weise sicherstellen.

Alternativ hierzu ist bekannt, die erforderliche Kapazitätsmessung in einem kapazitiven Feuchtesensor über eine Zeitmessung vorzunehmen. Eine entsprechende Schaltung ist z.B. aus dem Application Report SLAA071 (October 1999) der Firma Texas Instruments mit dem Titel "Economic Measurement Techniques with a Comparator_A Module (L. Bierl), S. 26 (Ziffer 2.7) bekannt. Ermittelt wird bei einem derartigen Vorgehen die Ladezeit, die erforderlich ist, um die Messkapazitäten auf eine vorgegebene Spannung aufzuladen. Insbesondere für die Messung von kleinen Kapazitäten ($C < 200pF$) ist hierbei jedoch eine hohe zeitliche Auflösung der Messung nötig. Steht die geforderte hohe Auflösung der Zeitmessung nicht zur Verfügung, so sind alternativ sehr hohe Widerstandswerte ($> 1M\Omega$) in der entsprechenden Schaltung erforderlich. Dies wirkt sich wiederum negativ auf die Stabilität der Schaltung gegenüber schwankender Verschmutzung oder Feuchtigkeit aus. Derartige Störungen können darüber hinaus zu Fehlmessungen führen, da während der Messung i.w. nur ein einziges Mal eine kleine Ladung bewegt wird. Resultiert genau zu diesem Zeitpunkt eine eventuelle Störung, so kann daraus eine fehlerhafte Kapazitätsbestimmung resultieren.

Eine weitere Variante zur Kapazitätsmessung ist aus der US 6,466,036 bekannt, um eine unbekannte Kapazität gegen Erde zu bestimmen. Hierbei wird vorgeschlagen, eine zu messende Kapazität mehrmalig aufzuladen und wieder zu entladen und parallel hierzu ein Ladungsspeicherelement mehrmalig aufzuladen bis ein Referenzwert erreicht ist. Aus der Zahl der Aufladevorgänge bis zum Erreichen des Referenzwertes erfolgt die Bestimmung der zu messenden Kapazität.

Aufgabe der vorliegenden Erfindung ist es, eine Schaltungsanordnung zur kapazitiven Feuchtemessung sowie ein Verfahren zum Betrieb derselben anzugeben. Hierbei soll mit möglichst geringem Aufwand ein zuverlässiger Messbetrieb gewährleistet sein.

Diese Aufgabe wird gelöst durch eine Schaltungsanordnung mit den Merkmalen des Anspruches 1.

Vorteilhafte Ausführungsformen der erfindungsgemäßen Schaltungsanordnung ergeben sich aus den Maßnahmen, die in den von Anspruch 1 abhängigen Patentansprüchen aufgeführt sind.

Ferner wird die angegebene Aufgabe durch ein Verfahren mit den Merkmalen des Anspruches 10 gelöst.

Vorteilhafte Ausführungsformen des erfindungsgemäßen Verfahrens ergeben sich aus den Maßnahmen, die in den von Anspruch 10 abhängigen Patentansprüchen aufgeführt sind.

Erfindungsgemäß wird nunmehr parallel das zu messende kapazitive Element und ein Ladungsspeicherelement aufgeladen und anschließend lediglich das kapazitive Element entladen. Während des Entladevorgangs wird sichergestellt, dass keine Entladung des Ladungsspeicherelements erfolgt. Dies wird solange wiederholt, bis die Ladung im Ladungsspeicherelement bzw. die Spannung am Ladungsspeicherelement einen vorgegebenen Referenzwert überschreitet. Aus der Zahl der bis zu diesem Zeitpunkt stattgefundenen Aufladevorgänge oder der Zeit bis zum Erreichen des Referenzwertes wird dann die zu messende Kapazität des kapazitiven Elements bestimmt.

In einer vorteilhaften Ausführungsform umfasst die erfindungsgemäße Schaltungsanordnung zwei zu messende kapazitive Elemente, nämlich ein kapazitives Feuchtesensorelement sowie ein kapazitives Referenzeiement mit bekannter Kapazität. Die Bestimmung der interessierenden Kapazität des Feuchtesensorelements lässt über zwei Messungen bewerkstelligen, in denen die beiden kapazitiven Elemente wie oben erläutert zyklisch aufgeladen und entladen werden und die jeweilige Anzahl derartiger Zyklen oder aber die verstrichene Zeit bis zum Erreichen des Referenzwertes bestimmt wird. In Verbindung mit der bekannten Kapazität des Referenzelements resultiert in einfacher Art und Weise die Kapazität des Feuchtesensorelements, welche wiederum in näherungsweise linearem Zusammenhang zur gesuchten Messgröße, d.h. der relativen Feuchte steht.

Als besonders vorteilhaft erweist sich die erfindungsgemäße Lösung aufgrund der geringen Anzahl erforderlicher Bauelemente. Hinzu kommt, dass die Kapazitätsmessung für das Referenzelement als auch für das Feuchtesensorelement mit den nahezu identischen Bauteilen erfolgen kann. Dies bedeutet, dass sich eventuelle Änderungen in der Versorgungsspannung, den Eingangsströmen etc. stets auf beide Teilmessungen gleich auswirken und demzufolge eliminierbar sind. Es resultiert hierdurch eine gesteigerte Messgenauigkeit.

Weitere Vorteile sowie Einzelheiten der vorliegenden Erfindung ergeben sich aus der nachfolgenden Beschreibung von Ausführungsbeispielen anhand der beiliegenden Figuren.

Dabei zeigt

Figur 1 ein stark schematisiertes Blockschaltbild einer Ausführungsform der erfindungsgemäßen Schaltungsanordnung;

Figur 2a, 2b jeweils ein Blockschaltbild einer Ausführungsform der erfindungsgemäßen Schaltungsanordnung in verschiedenen Phasen der Referenzelement-Teilmessung;

Figur 3 ein Ablaufdiagramm zur Erläuterung einer Ausführungsform des erfindungsgemäßen Verfahrens.

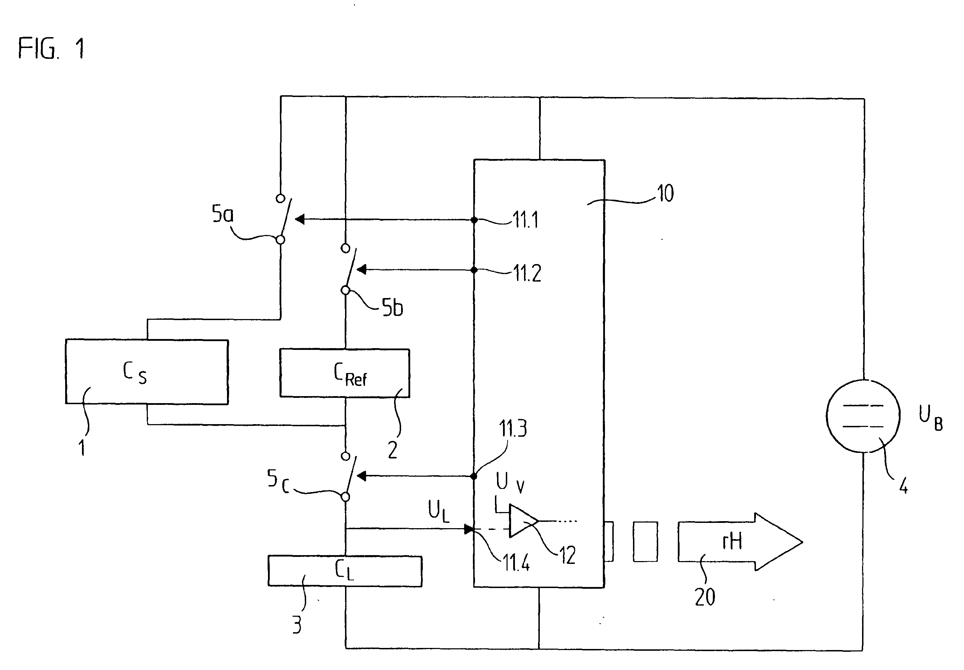

In Figur 1 ist ein stark schematisiertes Blockschaltbild einer möglichen Ausführungsform der erfindungsgemäßen Schaltungsanordnung zur kapazitiven Feuchtemessung dargestellt.

Das Ausführungsbeispiel der Schaltungsanordnung umfasst zwei kapazitive Elemente 1, 2, von denen ein erstes Element 1 als kapazitives Feuchtesensorelement ausgebildet ist und ein zweites Element 2 als kapazitives Referenzelement. Das Feuchtesensorelement 1 ist hierbei in bekannter Art und Weise aufgebaut und besteht wie eingangs erläutert aus zwei Metallelektroden, zwischen denen ein feuchteempfindliches Polymer angeordnet ist, wobei der Gesamtaufbau auf einem Glas-Trägersubstrat angeordnet ist. Geeignete kapazitive Feuchtesensorelemente 1 werden von der Anmelderin beispielsweise unter den Typenbezeichnungen HC 101, HC103 oder HC104 vertrieben.

Das kapazitive Feuchtesensorelement 1 besitzt wie bereits eingangs erläutert eine Kapazität $C_S$ als zu bestimmende elektrische Messgröße. Die Kapazität $C_S$ ändert sich in Abhängigkeit von der Umgebungsfeuchte rH in definierter Art und Weise. Beispielsweise beträgt bei einer relativen Umgebungsfeuchte rH = 0% die Kapazität $C_S \approx 160pF$ und bei einer relativen Umgebungsfeuchte rH = 76% die Kapazität $C_S \approx 202pF$. Bei einem näherungsweise angenommenen linearen Zusammenhang der Größen $C_S$ und rH beträgt demzufolge bei einer relativen Umgebungsfeuchte rH = 100% die Kapazität $C_S \approx 215pF$.

Das Referenzelement 2 ist als handelsüblicher Kondensator ausgebildet, z.B. als NP0-Kondensator, und besitzt die bekannte Kapazität $C_{Ref}$, beispielsweise $C_{Ref}$ = 180pF. Maßgeblich bei der Wahl eines geeigneten Referenzelements 2 ist aufgrund der üblicherweise erfolgenden Kalibrierung des Gesamtsystems bei einer definierten Feuchte hierbei nicht primär die exakte Kenntnis von $C_{Ref}$. Es muss lediglich gewährleistet sein, dass das Referenzelement 2 während der Messung stabil gegenüber Schwankungen in der Temperatur, der Spannung, der Betriebsdauer etc. ist.

Ferner umfasst die erfindungsgemäße Schaltungsanordnung ein Ladungsspeicherelement 3, welches ebenfalls als Kondensator ausgebildet ist und beispielsweise eine Kapazität $C_L$ = 1µF besitzt. Die Kapazität $C_L$ des Ladungsspeicherelements 3 wird vorzugsweise deutlich größer gewählt als die Kapazität $C_{Ref}$ des Referenzelements 2, d.h. $C_L \gg C_{Ref}$, um eine hinreichende Auflösung bei der Kapazitätsmessung zu erreichen. So ist das Verhältnis $C_L/C_S$ bzw. $C_L/C_{Ref}$ ein Maß für die Auflösung der erfindungsgemäßen Kapazitätsmessung. Je größer demzufolge dieses Verhältnis gewählt ist, desto größer ist die zur Verfügung stehende Messauflösung. Während der eigentlichen Messung ist sicherzustellen, dass sich die Kapazität $C_L$ des Ladungsspeicherelements 3 möglichst nicht ändert. Hierzu muss der Leckstrom und der Wert der Kapazität $C_L$ des Ladungsspeicherelements 3 über der gesamten Betriebstemperatur möglichst gering sein, damit sich bei einer schnelleren Temperaturänderung der Leckstrom zwischen der Messung mit dem Feuchtesensorelement 1 und der Messung mit dem Referenzelement 2 nicht ändert.

Über verschiedene Schaltelemente 5a, 5b, 5c kann das Ladungsspeicherelement 3 wahlweise seriell mit einem der beiden kapazitiven Elemente 1, 2 verbunden werden, ferner dient das Schaltelement 5c in geöffnetem Zustand dazu, eine Entladung des Ladungsspeicherelements 3 in einer bestimmten Messphase zu verhindern.

Die Schaltelemente 5a, 5b, 5c werden über die verschiedenen Ausgänge 11.1, 11.2, 11.3 der Steuereinheit in der gewünschten Art und Weise angesteuert und in die jeweils erforderliche Stellung gebracht.

Die verschiedenen Schaltelemente 5a, 5b, 5c können im vorliegenden Beispiel prinzipiell je drei Schaltstellungen I, II, III einnehmen, nämlich die

Schaltstellung I = Schaltelement geschlossen,
Schaltstellung II = Schaltelement geöffnet sowie
Schaltstellung III = Schaltelement geöffnet und geerdet (GND = -$U_B$).

In Figur 1 befinden sich die drei Schaltelemente 5a, 5b, 5c jeweils in der Schaltstellung II.

Im Hinblick auf die konkrete Ausgestaltung der Schaltelemente 5a, 5b, 5c gibt es neben der angedeuteten Realisierung als diskrete Bauelemente selbstverständlich verschiedenste Möglichkeiten. So können diese zusammen mit den weiteren Komponenten der erfindungsgemäßen Schaltungsanordnung in integrierter Form ausgebildet werden. Ferner können die Schaltelemente 5a, 5b bereits in der Steuereinheit bzw. dem Mikroprozessor soft- und/oder hardwaremäßig enthalten sein. Das Schaltelement 5c, das im wesentlichen eine Entladung des Ladungsspeicherelements 3 in einer Entladephase eines der beiden anderen Elemente 1 oder 2 verhindern soll, kann des weiteren auch als Diode ausgebildet sein usw.. Die Darstellung der Schaltelemente 5a, 5b, 5c in den Figuren als konkrete Schalter wurde primär aus Gründen der besseren Verständlichkeit des nachfolgend zu erläuternden Verfahrens gewählt.

Maßgeblich für die Funktionsweise der erfindungsgemäßen Schaltungsanordnung bzw. für das erfindungsgemäße Verfahren ist ferner eine Steuereinheit 10, die vorzugsweise als Mikroprozessor ausgebildet ist und u.a. eine Reihe von definiert schaltbaren Ein- und Ausgängen 11.1 - 11.4 bzw. Ports besitzt. Die verschiedenen Ein- und Ausgänge 11.1 - 11.4 der Steuereinheit 10 sind in der gezeigten Art und Weise mit den Schaltelementen 5a, 5b, 5c sowie mit einem Spannungsabgriff über dem Ladungsspeicherelement 3 verbunden. Zur Funktionsweise bzw. Ansteuerung der verschiedenen Schaltelemente 5a, 5b, 5c etc. sei auf die nachfolgende Erläuterung des erfindungsgemäßen Verfahrens verwiesen.

Die Steuereinheit 10 umfasst ferner eine mit dem Eingang 11.4 verbundene interne Vergleichereinheit 12 in Form eines Komparators, der zwei Eingänge aufweist. An einem ersten Eingang der Vergleichereinheit 12 liegt eine Messspannung $U_L$ an, die der Spannung über dem Ladungsspeicherelement 3 entspricht, am zweiten Eingang liegt eine vorgegebene Vergleichsspannung $U_V$ an. In einem möglichen Ausführungsbeispiel wird die Vergleichsspannung $U_V$ = 2.5V gewählt. Wichtig im Hinblick auf die Vergleichsspannung $U_V$ ist im übrigen weniger deren Betrag als vielmehr deren Stabilität bzw. Konstanz im Verlauf der Messung. Auf die Funktion der Vergleichereinheit 12 wird in der nachfolgenden Beschreibung ebenfalls näher eingegangen.

Die Strom- bzw. Spannungsversorgung der erfindungsgemäßen Schaltungsanordnung erfolgt über ein schematisiert angedeutetes Netzgerät 4. Dieses liefert eine Betriebsspannung $U_B$ (z.B. zwischen 2.3V und 5.5V), mit der sowohl die Steuereinheit 10 versorgt wird als auch das Aufladen der verschiedenen kapazitiven Elemente 1, 2 sowie des Ladungsspeicherelements 3 im Rahmen des erfindungsgemäßen Verfahrens erfolgt. In einem Ausführungsbeispiel wird etwa $U_B$ = 5V gewählt; die Vergleichsspannung $U_V$ beträgt wie oben erwähnt dann beispielsweise $U_V$ = 2.5V.

Schematisiert angedeutet ist in Verbindung mit der Steuereinheit 10 ferner ein Ausgang 20, an dem die letztlich interessierende Messgröße, d.h. die ermittelte relative Feuchte rH, in digitaler Form zur Weiterverarbeitung zur Verfügung steht.

Mittels der dargestellten Schaltungsanordnung lässt sich prinzipiell sowohl die Kapazität $C_S$ des kapazitiven Feuchtesensorelementes 1 als auch die Kapazität $C_{Ref}$ des kapazitiven Referenzelementes 2 separat bestimmen. Nachfolgend sei die Bestimmung der Kapazität $C_S$ des Feuchtesensorelementes 1 beispielhaft erläutert.

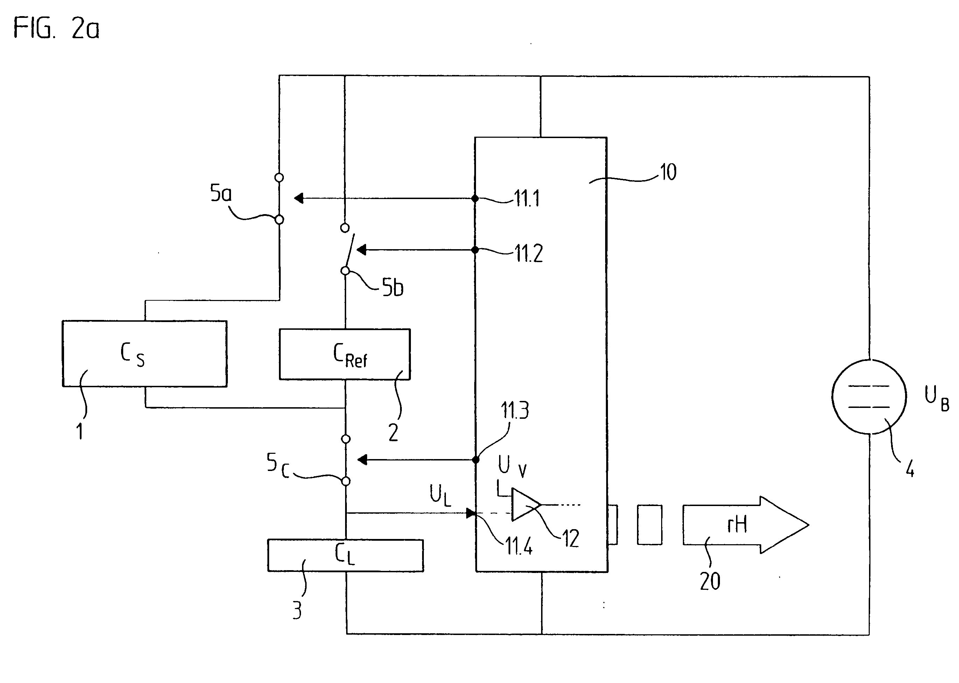

Vor Beginn der Kapazitätsbestimmung ist sicherzustellen, dass alle vorhandenen Kapazitäten $C_S$, $C_{Ref}$, $C_L$ in der erfindungsgemäßen Schaltungsanordnung möglichst vollständig entladen werden. Zur eigentlichen Messung wird das Feuchtesensorelementes 1, über die verschiedenen Schaltelemente 5a, 5b, 5c zunächst in einem ersten Aufladevorgang mit dem Ladungsspeicherelement 3 in Serie geschaltet und sowohl das Feuchtesensorelementes 1 als auch das Ladungsspeicherelement 3 um einen bestimmten Ladungsbetrag Qn aufgeladen. In Figur 2a ist der hierzu erforderliche Schaltzustand der verschiedenen Schaltelemente 5a, 5b, 5c in dieser Messphase dargestellt. Während über den Ausgang 11.2 der Steuereinheit 10 das Schaltelement 5b geöffnet bleibt (Schaltzustand II), um die Aufladung des Referenzelements 2 zu verhindern, bleiben über die Ausgänge 11.1, 11.3 angesteuert die Schaltelemente 5a, 5c geschlossen (Schaltzustand I).

Der bei diesem Aufladevorgang in die Kapazitäten eingebrachte Ladungsbetrag Qn ergibt sich hierbei grundsätzlich gemäß

$$Qn = C * dU \qquad (\text{Gl. 1}),$$

wobei:

C    := Kapazität des Feuchtesensorelement/Ladungsspeicherelements
dU   := am Feuchtesensorelement/Ladungsspeicherelement anliegende Spannung

Wenn davon ausgegangen wird, dass sämtliche Kapazitäten bzw. Kondensatoren der Anordnung vor dem ersten Aufladevorgang vollständig entladen waren, so ergibt sich die in das Feuchtesensorelement 1 eingebrachte Ladung Qn näherungsweise folgendermaßen:

$$Qn = C_S * dU_S = C_S * U_S = C_S * (U_B - U_D - U_L) \qquad Gl.\ (2),$$

wobei:

$C_S$ := Kapazität des Feuchtesensorelementes 1
$U_S$ := Spannung am Feuchtesensorelement 1
$U_B$ := Betriebsspannung des Netzgeräts 4
$U_D$ := Spannung an der Diode 6
$U_L$ := Spannung an Ladungsspeicherelement 3

Mit den beispielhaften Werten $C_S$ = 180pF, $U_B$ = 5.0V, $U_D$ = 0.3V, $U_L$ = 0.0V für den ersten Ladevorgang ergibt sich Qn = 846pC. Wird dieser Ladungsbetrag wie erläutert auch in das Ladungsspeicherelement 3 eingebracht, so resultiert an diesem ein Spannungsanstieg $dU_L$ gemäß

$$dU_L = Qn / C_L = 846pC / 1\mu F = 0.846mV.$$

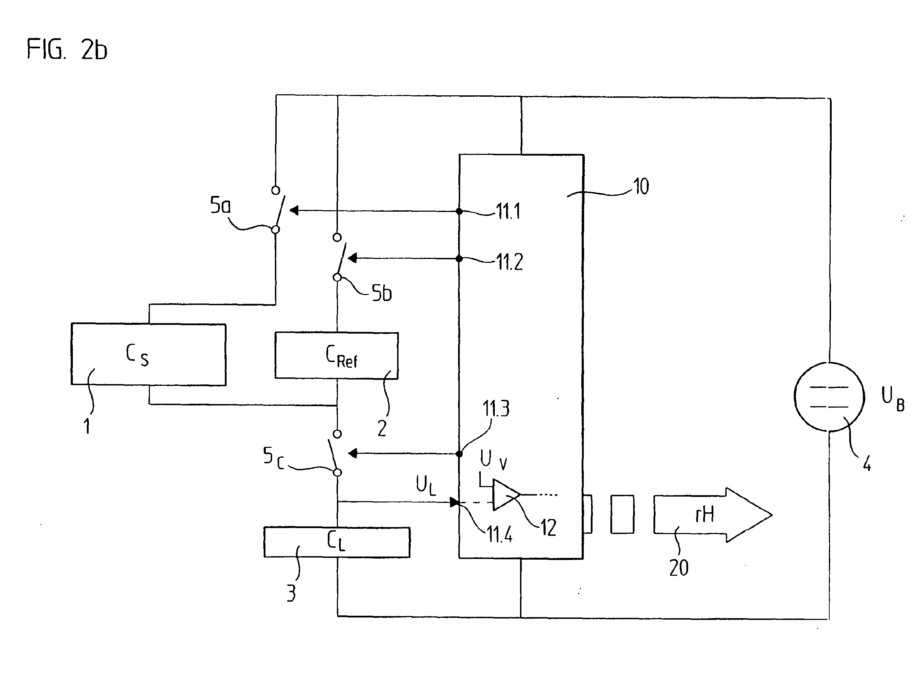

Im nachfolgenden Verfahrensschritt wird dann lediglich das kapazitive Feuchtesensorelement vollständig entladen, während durch Schaltelement 5c verhindert wird, dass gleichzeitig eine Entladung des Ladungsspeicherelementes 3 resultiert. Der entsprechende Zustand der verschiedenen Schaltelemente 5a, 5b, 5c in dieser Messphase ist in Figur 2b veranschaulicht. Während das Schaltelement 5b wiederum geöffnet im Schaltzustand II bleibt, wird im Unterschied zur vorherigen Messphase nunmehr das Schaltelement 5a über den Ausgang 11.1 angesteuert und befindet sich zur Entladung des Feuchtesensorelementes 1 im Schaltzustand III. Das Schaltelement 5c befindet sich hingegen im Schaltzustand II und ist geöffnet, womit eine Entladung des Ladungsspeicherelementes 3 verhindert wird. Wie bereits oben angedeutet kann die Funktionalität des Schaltelements 5c auch durch eine geeignet angeordnete Diode an dieser Stelle realisiert werden.
Bei der Entladung des Feuchtesensorelementes 1 ist sicherzustellen, dass die Spannung am Feuchtesensorelement 1 die Versorgungsspannung $U_B$ nicht übersteigt bzw. nicht unter den Wert GND sinkt, damit nicht die Steuereinheit 10 ggf. beschädigt wird. Dies lässt sich z.B. gewährleisten, indem wie erläutert Schaltelement 5a in der Schalterstellung III ist und die Entladung des Feuchtesensorelementes 1 über Schutzdioden gegen das Netzgerät 4 erfolgt.
Anschließend erfolgt in einem zweiten Zyklus wiederum eine parallele Aufladung des kapazitiven Feuchtesensorelementes 1 und des Ladungsspeicherelementes 3, bevor daraufhin erneut nur die Entladung des kapazitiven Feuchtesensorelementes 1 resultiert. Aufgrund der jeweils verhinderten Entladung des Ladungsspeicherelements 3 steigt die an diesem Element 3 anliegende Spannung $U_L$ an.
Diese Schritte wiederholen sich anschließend insgesamt N_$C_S$ mal, wobei das Ladungsspeicherelement 3 im Verlauf der sich aneinander anschließenden Aufladezyklen immer weiter aufgeladen wird, d.h. die Spannung $U_L$ steigt dabei an, bis die bereits oben erläuterte Vergleichsspannung $U_V$ bzw. Referenzwert erreicht wird. Beim Erreichen der Vergleichsspannung $U_V$ wird in dieser Ausführungsform des erfindungsgemäßen Verfahrens die Zahl N_$C_S$ der bis zu diesem Zeitpunkt erfolgten Aufladevorgänge bestimmt. Da die Zahl N_$C_S$ der erfolgten Aufladevorgänge direkt proportional zur Kapazität $C_S$ des Feuchtesensorelementes 1 ist, lässt sich bei bekannter Kapazität $C_L$ aus der Zahl N_$C_S$ der erfolgten Aufladevorgänge auch direkt die zu messende Kapazität $C_S$ des Feuchtesensorelementes 1 ermitteln.
Schaltungstechnisch wird dieses Vorgehen dadurch umgesetzt, dass die Spannung $U_L$ am Ladungsspeicherelement 3 über den Eingang 11.4 der Steuereinheit einem ersten Eingang der Vergleichereinheit 12 bzw. dem Komparator in der Steuereinheit 10 zugeführt wird, während am zweiten Eingang der Vergleichereinheit 12 die Vergleichsspannung $U_V$ = 2.5V anliegt. Erreicht nach N_$C_S$ Aufladevorgängen demzufolge die Spannung $U_L$ am Ladungsspeicherelement 3 die Vergleichsspannung $U_V$, so wird über die Vergleichereinheit 12 ein entsprechendes Ausgangssignal erzeugt, mit dem dann der aktuelle Zählerstand N_$C_S$ einer - nicht dargestellten - Zählereinheit eingefroren wird, die die Zahl der erfolgenden Aufladevorgänge mitzählt.
Grundsätzlich ließe sich über das erläuterte Vorgehen demzufolge die Kapazität $C_S$ des Feuchtesensorelementes 1 ermitteln, d.h. allein aus der Ermittlung der Zahl N_$C_S$ der bis zum Erreichen Vergleichsspannung $U_V$ erfolgenden Aufladevorgänge wäre grundsätzlich die Bestimmung von $C_S$ möglich, wenn entsprechend dem erläuterten Vorgehen regelmäßig das Feuchtesensorelement 1 parallel zum Ladungsspeicherelement 3 aufgeladen und entladen wird. Um die bei einem derartigen Vorgehen resultierenden Fehlerquellen in Verbindung mit sich ggf. ändernden Schaltungsparametern auszuschließen, werden jedoch vorzugsweise zwei Teilmessungen durchgeführt, bei denen analog zum oben beschriebenen Vorgehen zunächst die Zahl $N\_C_{Ref}$ der erfolgten Aufladevorgänge für das Referenzelement 2 ermittelt wird und anschließend wie erläutert die Zahl $N\_C_S$ der erfolgten Aufladevorgänge für das Feuchtesensorelement 1 bis jeweils die Vergleichsspannung $U_V$ bzw. der Referenzwert erreicht ist.

Für die erste erfolgende Teilmessung zur Bestimmung von $N\_C_{Ref}$ ist durch die entsprechende Betätigung der Schaltelemente 5a, 5b über die Ausgänge 11.1, 11.2 jeweils das Referenzelement 2 anstelle des Feuchtesensorelementes 1 aktiv zu schalten. Das heißt, dass in der Ladephase das Schaltelement 5b geschlossen (Schaltzustand I), das Schaltelement 5a geöffnet (Schaltzustand II) und das Schaltelement 5c geschlossen ist (Schaltzustand I) usw..

Aufgrund der oben erwähnten direkten Proportionalität der Anzahl erforderlicher Aufladevorgänge zur jeweiligen Kapazität, lässt sich bei bekannter Referenzkapazität $C_{Ref}$ die gesuchte elektrische Messgröße $C_S$ dann gemäß folgender Gleichung (3) ermitteln:

$$C_S = C_{Ref} * (N\_C_{Ref} / N\_C_S) \qquad (Gl. 3)$$

Für den Beispielfall rH = 0% ergibt sich etwa mit den gemessenen Werten $N\_C_{Ref}$ = 4218, $N\_C_S$ = 4746 und $C_{Ref}$ = 180pF die gesuchte Kapazität $C_S$ korrekt zu $C_S$ = 159,97pF ≈ 160pF.

Als maßgeblicher Vorteil dieses Vorgehens ist anzuführen, dass sich derart eine weitgehende Unempfindlichkeit gegenüber eventuellen Änderungen in den verschiedenen Bauteilen erreichen lässt. Derartige Änderungen wirken sich dann auf die beiden Teilmessungen gleich aus und verursachen keinen Messfehler bei der Kapazitätsbestimmung.

So hat etwa eine mögliche temperaturbedingte Änderung der Kapazität $C_L$ des Ladungsspeicherelementes 3 keine wesentlichen Auswirkungen auf die Bestimmung der Kapazität $C_S$. Ändert sich die Kapazität $C_L$ etwa aufgrund von Temperatureinflüssen von $C_L$ = 1000nF auf $C_L$ =1100nF, so ergeben sich als Messgrößen $N\_C_{Ref}$ = 4640 und $N\_C_S$ = 5220, d.h. gemäß Gl. (3) resultiert eine ermittelte Kapazität $C_S$ = 160.0pF für das Feuchtesensorelement 1. Die fehlerbedingte Änderung im ermittelten Wert für $C_S$ liegt unterhalb der Auflösungsgrenze der erfindungsgemäßen Schaltungsanordnung und ist daher unkritisch.

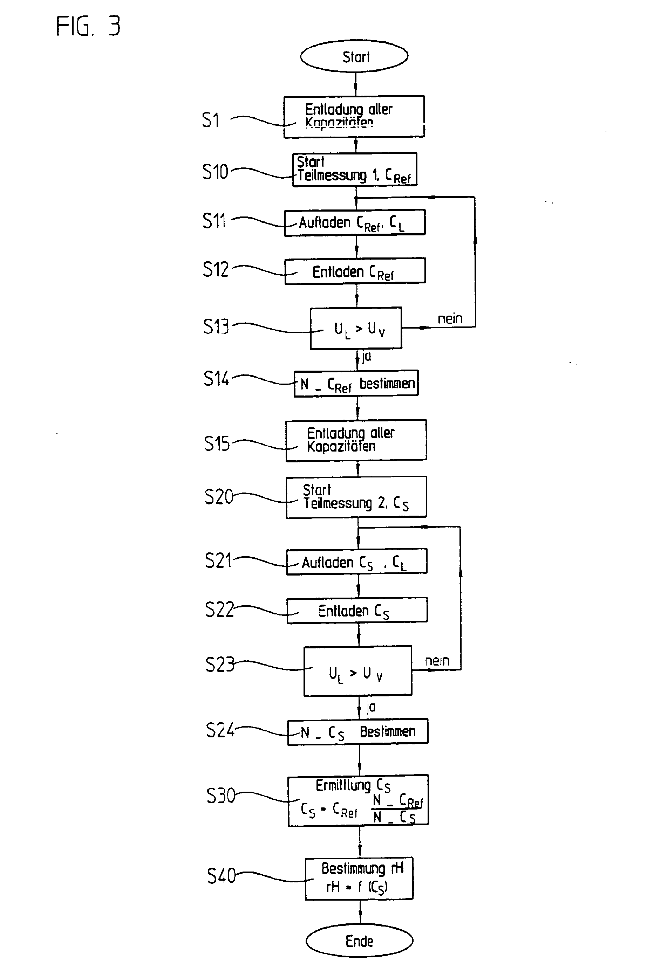

In Figur 3 ist die Vorgehensweise im Rahmen einer vorteilhaften Ausführungsform des erfindungsgemäßen Verfahrens in einem Ablaufdiagramm noch einmal dargestellt, über das die relative Umgebungsfeuchte rH bestimmt wird.

Nach dem Messstart und der Entladung aller Kapazitäten im Schritt S1 beginnt im Schritt S10 die erste Teilmessung, in der zunächst das Referenzelement vermessen wird. Hierzu erfolgt im ersten Auflade-/Entlade-Zyklus gemäß dem Verfahrensschritt S11 das Aufladen des Referenzelementes und des Ladungsspeicherelements, die die (bekannten) Kapazitäten $C_{Ref}$ und $C_L$ aufweisen. Im Verfahrensschritt S11 wird das Referenzelement mit der Kapazität $C_{Ref}$ entladen, während wie oben erläutert die Entladung des Ladungsspeicherelements verhindert wird. Daraufhin wird im Schritt S13 überprüft, ob die im Ladungsspeicherelement enthaltene Ladung bzw. die hierzu korrespondierende Spannung $U_L$ einen vorgegebenen Referenzwert bzw. Vergleichsspannung $U_V$ schon überschritten hat. Ist dies nicht der Fall folgt ein erneuter Auflade-/Entladezyklus usw.; ist die Vergleichsspannung $U_V$ hingegen überschritten, wird im Schritt S14 die Anzahl $N\_C_{Ref}$ der bis zu diesem Zeitpunkt erfolgten Auflade-/Entladezyklen bestimmt und festgehalten. Zum Abschluss der ersten Teilmessung bzw. vor der zweiten Teilmessung erfolgt darauf im Schritt S15 eine vollständige Entladung aller Kapazitäten in der Schaltungsanordnung, insbesondere des Referenzelements, des Feuchtesensorelements sowie des Ladungsspeicherelements, um derart an allen Kondensatoren wieder gleiche Anfangsbedingungen mit U = 0V herzustellen.

Anschließend beginnt mit dem Schritt S20 die zweite Teilmessung, in der das Feuchtesensorelement mit der feuchteabhängigen Kapazität $C_S$ vermessen wird. Analog zum vorherigen Vorgehen wird im Schritt S21 zunächst das Feuchtesensorelement und das Ladungsspeicherelement aufgeladen und im Schritt S22 lediglich das Feuchtesensorelement mit der Kapazität $C_S$ entladen. Im Schritt S23 erfolgt ebenfalls analog zum Vorgehen in der ersten Teilmessung die Überprüfung, ob die im Ladungsspeicherelement enthaltene Ladung bzw. die hierzu korrespondierende Spannung $U_L$ einen vorgegeben Referenzwert bzw. die Vergleichsspannung $U_V$ schon überschritten hat. Ist dies nicht der Fall, folgt eine erneuter Auflade-/Entladezyklus usw.; ist die Vergleichsspannung $U_V$ hingegen überschritten, wird im Schritt S24 die Anzahl $N\_C_S$ der bis zu diesem Zeitpunkt erfolgten Auflade/Entladezyklen bestimmt und festgehalten.

Im Verfahrensschritt S30 kann über die oben erläuterte Gleichung (3) aus der bekannten Kapazität $C_{Ref}$ des Referenzelements und den beiden Messwerten $N\_C_S$, $N\_C_{Ref}$ die gesuchte Messgröße in Form der Kapazität $C_S$ des Feuchtesensorelements ermittelt werden.

Aus der Kapazität $C_S$ des Feuchtesensorelements wird im Verfahrensschritt S40 schließlich in bekannter Art und Weise die relative Feuchte rH als Funktion der Größe $C_S$ bestimmt. Die relative Feuchte rH steht dann zur Weiterverarbeitung in der jeweiligen Anwendung zur Verfügung.

Selbstverständlich lässt sich die Schaltungsanordnung bzw. das Verfahren im Rahmen der vorliegenden Erfindung in vielfältiger Weise abwandeln.

So sei darauf hingewiesen, dass es in Verbindung mit der beispielhaft erläuterten Schaltungsanordnung selbstverständlich weitere soft- und hardwaremäßige Ausführungsvarianten gibt.

So kann etwa vorgesehen werden, seriell zu den verschiedenen Kapazitäten einen Widerstand anzuordnen, um derart die Ladeströme der Kondensatoren zu begrenzen.

Des Weiteren ist es im Rahmen des erfindungsgemäßen Verfahrens möglich, die Reihenfolge der beiden Teilmessungen zu vertauschen, d.h. etwa zunächst das Feuchtesensorelement zu vermessen und dann erst das Referenzelement etc..

Ferner kann alternativ zum erläuterten Vorgehen als Messgröße nicht die Anzahl der erfolgten Aufladevorgänge bis zum Erreichen des Referenzwertes respektive der Vergleichsspannung $U_V$ ermittelt werden sondern die bis zu diesem Zeitpunkt verstrichene Zeit $t_S$ (Messung des Feuchtesensorelements) bzw. $t_{Ref}$ (Messung des Feuchtesensorelements). Die Bestimmung der relativen Feuchte erfolgt analog zum vorhergehend beschriebenen Vorgehen, wobei in GI. (3) dann entsprechend die Größen $N\_C_{Ref}$ und $N\_C_S$ gegen die Größen $t_S$ und $t_{Ref}$ zu ersetzen sind. Auf Seiten der Steuereinheit sind anstelle der oben erwähnten Zählereinheit dann entsprechende Mittel zur Zeitmessung vorzusehen etc..

**Patentansprüche**

1. Schaltungsanordnung zur kapazitiven Feuchtemessung, bestehend aus

   - mindestens einem zu messenden kapazitiven Element (1, 2),
   - mehreren Schaltelementen (5a, 5b, 5c),
   - mindestens einem Ladungsspeicherelement (3) sowie
   - einer Steuereinheit (10),

   wobei die Steuereinheit (10) derart ausgebildet ist, dass über die Schaltelemente (5a, 5b, 5c) ein Aufladen und Entladen des kapazitiven Elements (1, 2) sowie ein hierzu paralleles Aufladen des Ladungsspeicherelements (3) erfolgt bis dieses auf einen bestimmten Referenzwert aufgeladen ist und aus der Ermittlung der Anzahl ($N\_C_{Ref}$, $N\_C_S$) der Aufladevorgänge oder der Zeit ($t_S$, $t_{Ref}$) bis zum Erreichen des Referenzwertes eine Bestimmung der Kapazität ($C_S$, $C_{Ref}$) des kapazitiven Elements (1, 2) erfolgt, wobei zwischen dem Ladungsspeicherelement (3) und dem kapazitiven Element (1, 2) ein Schaltelement (5c) derart angeordnet ist, dass ein Entladen des Ladungsspeicherelements (3) während der Entladung des kapazitiven Elements (1, 2) nicht möglich ist.

2. Schaltungsanordnung nach Anspruch 1, die zwei zu messende kapazitive Elemente (1, 2) umfasst, von denen ein erstes als kapazitives Feuchtesensorelement (1) und ein zweites als kapazitives Referenzelement (2) ausgebildet ist und mittels der Schaltelemente (5a, 5b, 5c) wahlweise jeweils eines der beiden Elemente (1, 2) seriell mit dem Ladungsspeicherelement (3) und der Steuereinheit (10) zur Kapazitätsbestimmung verbindbar ist.

3. Schaltungsanordnung nach Anspruch 1, wobei das Ladungsspeicherelement (3) als Kondensator ausgebildet ist und mit dem kapazitiven Element (1, 2) zur Kapazitätsbestimmung in Serie geschaltet angeordnet ist.

4. Schaltungsanordnung nach Anspruch 3, wobei das zwischen dem Ladungsspeicherelement (3) und dem kapazitiven Element (1, 2) angeordnete Schaltelement (5c) als Diode ausgebildet ist.

5. Schaltungsanordnung nach mindestens einem der vorhergehenden Ansprüche, wobei die Steuereinheit (10) als Mikroprozessor ausgebildet ist, der zur Kapazitätsmessung eine Reihe von definiert programmierbaren Ein- und Ausgängen (11.1 - 11.4) aufweist, die mit den Schaltelementen (11.1 - 11.4) und mit dem Ladungsspeicherelement (3) verbunden sind.

6. Schaltungsanordnung nach mindestens einem der vorhergehenden Ansprüche, wobei die Steuereinheit (10) eine Vergleichereinheit (12) mit zwei Eingängen umfasst und an einem ersten Eingang als Referenzwert eine vorgegebene Vergleichsspannung ($U_V$) anliegt und an einem zweiten Eingang eine am Ladungsspeicherelement (3) abgegriffene Spannung ($U_L$) anliegt, so dass im Fall des Überschreitens der Vergleichsspannung ($U_V$) durch die am Ladungsspeicherelement (3) abgegriffene Spannung ($U_L$) ein definiertes Ausgangssignal der Vergleichereinheit (12) resultiert.

7. Schaltungsanordnung nach Anspruch 6, wobei die Steuereinheit (10) ferner eine Zählereinheit aufweist, die die Anzahl (N_C$_{Ref}$, N_C$_S$) der erfolgenden Aufladevorgänge bis zum Überschreiten der Vergleichsspannung (U$_V$) erfasst.

8. Schaltungsanordnung nach Anspruch 2, wobei das kapazitive Referenzelement (2) eine vorbekannte Kapazität (C$_{Ref}$) besitzt.

9. Schaltungsanordnung nach Anspruch 8, wobei die Steuereinheit (10) derart ausgebildet ist, dass aus den in zwei Teilmessungen ermittelten Anzahlen (N_C$_{Ref}$, N_C$_S$) von erforderlichen Aufladevorgängen für das Referenzelement (2) und das Feuchtesensorelement (1) und der bekannten Kapazität (C$_{Ref}$) des Referenzelements (2) die Kapazität (C$_S$) des Feuchtesensorelements (1) und aus dieser wiederum die relative Umgebungsfeuchte (rH) bestimmbar ist.

10. Verfahren zum Betrieb einer Schaltungsanordnung zur kapazitiven Feuchtemessung, die mindestens ein kapazitives Element (1, 2), mehrere Schaltelemente (5a, 5b, 5c), ein Ladungsspeicherelement (3) sowie eine Steuereinheit (10) umfasst, wobei die Steuereinheit (10) mittels der Schaltelemente (5a, 5b, 5c) ein Aufladen und Entladen des kapazitiven Elements (1, 2) sowie ein hierzu paralleles Aufladen des Ladungsspeicherelements (3) vornimmt, bis dieses auf einen bestimmten Referenzwert aufgeladen ist und aus der Ermittlung der Anzahl (N_C$_{Ref}$, N_C$_S$) der Aufladevorgänge oder der Zeit (t$_S$, t$_{Ref}$) bis zum Erreichen des Referenzwertes eine Bestimmung der Kapazität (C$_S$, C$_{Ref}$) des kapazitiven Elements (1, 2) vorgenommen wird, wobei über ein zwischen dem Ladungsspeicherelement (3) und dem kapazitiven Element (1, 2) angeordnetes Schaltelement (5c) ein Entladen des Ladungsspeicherelements (3) während der Entladung des kapazitiven Elements (1, 2) verhindert wird.

11. Verfahren nach Anspruch 10, wobei die Schaltungsanordnung zwei zu messende kapazitive Elemente (1, 2) umfasst, von denen ein erstes als kapazitives Feuchtesensorelement (1) und ein zweites als kapazitives Referenzelement (2) ausgebildet ist und mittels der Schaltelemente (5a, 5b, 5c) wahlweise jeweils eines der beiden Elemente (1, 2) mit dem Ladungsspeicherelement (3) und der Steuereinheit (10) verbunden wird.

12. Verfahren nach mindestens einem der vorhergehenden Ansprüche, wobei die Steuereinheit (10) als Mikroprozessor ausgebildet ist, der zur Kapazitätsmessung eine Reihe von definiert programmierbaren Ein- und Ausgängen (11.1 - 11.4) aufweist, die mit den Schaltelementen (5a, 5b, 5c) und mit dem Ladungsspeicherelement (3) verbunden werden.

13. Verfahren nach mindestens einem der vorhergehenden Ansprüche, wobei zur Ermittlung der Anzahl (N_C$_{Ref}$, N_C$_S$) der Aufladevorgänge oder der Zeit (t$_S$, t$_{Ref}$) bis zum Erreichen des Referenzwertes die Steuereinheit (10) eine Vergleichereinheit (12) mit zwei Eingängen umfasst und an einem ersten Eingang als Referenzwert eine vorgegebene Vergleichsspannung (U$_V$) anliegt und an einem zweiten Eingang eine am Ladungsspeicherelement (3) abgegriffene Spannung (U$_L$) anliegt und beim Überschreiten der Vergleichsspannung (U$_V$) durch die am Ladungsspeicherelement (3) abgegriffene Spannung (U$_L$) die Anzahl (N_C$_{Ref}$, N_C$_S$) der bis zu diesem Zeitpunkt erfolgten Aufladevorgänge oder die Zeit (t$_S$, t$_{Ref}$) bis zum Erreichen des Referenzwertes ermittelt wird.

14. Verfahren nach Anspruch 11, wobei

- in einer ersten Teilmessung mit dem Referenzelement (2) die Anzahl (N_C$_{Ref}$) der erforderlichen Aufladevorgänge oder die Zeit (t$_{Ref}$) bis zum Erreichen des Referenzwertes ermittelt wird,
- in einer zweiten Teilmessung mit dem Feuchtesensorelement (1) die Anzahl (N_C$_S$) der erforderlichen Aufladevorgänge oder die Zeit (t$_S$) bis zum Erreichen des Referenzwertes ermittelt wird und
- aus den ermittelten Anzahlen (N_C$_{Ref}$, N_C$_S$) von Aufladevorgängen oder den Zeiten (t$_{Ref}$, t$_S$) bis zum Erreichen des Referenzwertes von Aufladevorgängen und der bekannten Kapazität (C$_{Ref}$) des Referenzelementes (2) die Kapazität (C$_S$) des Feuchtesensorelements (1) bestimmt wird

15. Verfahren nach Anspruch 14, wobei die Kapazität (C$_S$) des Feuchtesensorelements (1) gemäß folgender Beziehung bestimmt wird:

$$C_S = C_{Ref} * (N\_C_{Ref} / N\_C_S),$$

wobei

$C_S$ := Kapazität des Feuchtesensorelements
$C_{Ref}$ := Kapazität des Referenzelements
$N\_C_{Ref}$ := Anzahl der Aufladevorgänge bei Teilmessung mit Referenzelement
$N\_C_S$ := Anzahl der Aufladevorgänge bei Teilmessung mit Feuchtesensorelement

16. Verfahren nach Anspruch 14, wobei zwischen der ersten und zweiten Teilmessung das Referenzelement (2), das Feuchtsensorelement (1) und das Ladungsspeicherelement (3) vollständig entladen werden.

17. Verfahren nach Anspruch 14, wobei aus der Kapazität ($C_S$) des Feuchtesensorelements (1) die relative Umgebungsfeuchte (rH) bestimmt wird.

18. Verfahren nach Anspruch 10, wobei

- zunächst über die Steuereinheit (10) sowohl das kapazitive Element (1, 2) als auch das Ladungsspeicherelement (3) mit einer bestimmten Ladung aufgeladen werden,
- anschließend das kapazitive Element (1, 2) entladen wird, während die im Ladungsspeicherelement (3) enthaltene Ladung unverändert bleibt,
- anschließend die vorhergehenden Schritte solange wiederholt werden, bis die Ladung im Ladungsspeicherelement (3) einen vorbestimmten Referenzwert erreicht und
- die Zahl ($N\_C_{Ref}$, $N\_C_S$) der beim Erreichen des Referenzwerts erfolgten Aufladevorgänge oder die Zeit ($t_S$, $t_{Ref}$) bis zum Erreichen des Referenzwertes ermittelt wird, um daraus die Kapazität ($C_S$, $C_{Ref}$) des kapazitiven Elements (1, 2) zu bestimmen.

## Claims

1. Circuit arrangement for capacitive moisture measurement, comprising

   - at least one capacitive element (1, 2) which is to be measured,
   - a plurality of circuit elements (5a, 5b, 5c),
   - at least one charge-coupled device (3) and also
   - a control unit (10),

   the control unit (10) being configured such that charging and discharging of the capacitive element (1, 2) and also charging of the charge-coupled device (3), which is parallel thereto, is effected via the circuit elements (5a, 5b, 5c) until said charge-coupled device is charged up to a specific reference value, and from determination of the number ($N\_C_{Ref}$, $N\_C_S$) of charging processes or the time ($t_S$, $t_{Ref}$) until attainment of the reference value, determination of the capacitance ($C_S$, $C_{Ref}$) of the capacitive element (1, 2) is effected, a circuit element (5c) being disposed between the charge-coupled device (3) and the capacitive element (1,2) such that discharge of the charge-coupled device (3) during discharge of the capacitive element (1, 2) is not possible.

2. Circuit arrangement according to claim 1, which comprises two capacitive elements (1, 2) which are to be measured, of which a first is configured as a capacitive moisture sensor element (1) and a second as a capacitive reference element (2) and, by means of the circuit elements (5a, 5b, 5c), optionally one of the two elements (1, 2) respectively can be connected in series to the charge-coupled device (3) and to the control unit (10) for capacitance determination.

3. Circuit arrangement according to claim 1, the charge-coupled device (3) being configured as a condenser and being disposed connected in series to the capacitive element (1,2) for capacitance determination.

4. Circuit arrangement according to claim 3, the circuit element (5c) which is disposed between the charge-coupled device (3) and the capacitive element (1,2) being configured as a diode.

5. Circuit arrangement according to at least one of the preceding claims, the control unit (10) being configured as a microprocessor which, for capacitance measurement, has a series of inputs and outputs (11.1 - 11.4) which are programmable in a defined manner and are connected to the circuit elements (11.1 - 11.4) and to the charge-coupled device (3).

6. Circuit arrangement according to at least one of the preceding claims, the control unit (10) comprising a comparator unit (12) with two inputs and a prescribed comparison voltage ($U_V$) being applied to a first input as reference value and a voltage ($U_L$), which is tapped at the charge-coupled device (3) being applied to a second input so that, in the case where the comparison voltage ($U_V$) is exceeded by the voltage ($U_L$) which is tapped at the charge-coupled device (3), a defined output signal of the comparator unit (12) results.

7. Circuit arrangement according to claim 6, the control unit (10) furthermore having a counter unit which detects the number ($N\_C_{Ref}$, $N\_C_S$) of effected charging processes until the comparison voltage ($U_V$) is exceeded.

8. Circuit arrangement according to claim 2, the capacitive reference element (2) having a previously known capacitance ($C_{Ref}$).

9. Circuit arrangement according to claim 8, the control unit (10) being configured such that, from the numbers ($N\_C_{Ref}$, $N\_C_S$) of required charging processes, determined in two partial measurements, for the reference element (2) and the moisture sensor element (1), and from the known capacitance ($C_{Ref}$) of the reference element (2), the capacitance ($C_S$) of the moisture sensor element (1) can be determined and from the latter, in turn, the relative ambient humidity (rH) can be determined.

10. Method for operating a circuit arrangement for capacitive moisture measurement, which comprises at least one capacitive element (1, 2), a plurality of circuit elements (5a, 5b, 5c), a charge-coupled device (3) and also a control unit (10), the control unit (10) undertaking, by means of the circuit elements (5a, 5b, 5c), charging and discharging of the capacitive element (1, 2) and also charging of the charge-coupled device (3), which is parallel thereto, until said charge-coupled device is charged up to a specific reference value, and from determination of the number ($N\_C_{Ref}$, $N\_C_S$) of charging processes or the time ($t_S$, $t_{Ref}$) until attainment of the reference value, determination of the capacitance ($C_S$, $C_{Ref}$) of the capacitive element (1, 2) is undertaken, discharge of the charge-coupled device (3) during discharge of the capacitive element (1, 2) being prevented via a circuit element (5c) which is disposed between the charge-coupled device (3) and the capacitive element (1, 2).

11. Method according to claim 10, the circuit arrangement comprising two capacitive elements (1, 2) which are to be measured, of which a first is configured as a capacitive moisture sensor element (1) and a second as a capacitive reference element (2) and, by means of the circuit elements (5a, 5b, 5c), optionally one of the two elements (1, 2) respectively is connected to the charge-coupled device (3) and to the control unit (10).

12. Method according to at least one of the preceding claims, the control unit (10) being configured as a microprocessor which, for capacitance measurement, has a series of inputs and outputs (11.1 - 11.4) which are programmable in a defined manner and are connected to the circuit elements (5a, 5b, 5c) and to the charge-coupled device (3).

13. Method according to at least one of the preceding claims, the control unit (10) comprising a comparator unit (12) with two inputs, for determination of the number ($N\_C_{Ref}$, $N\_C_S$) of charging processes or of the time ($t_S$, $t_{Ref}$) until attainment of the reference value, and a prescribed comparison voltage ($U_V$) being applied to a first input as reference value and a voltage ($U_L$), which is tapped at the charge-coupled device (3), being applied to a second input and, in the case where the comparison voltage ($U_V$) is exceeded by the voltage ($U_L$) which is tapped at the charge-coupled device (3), the number ($N\_C_{Ref}$, $N\_C_S$) of charging processes which have been effected up to this point in time or the time ($t_S$, $t_{Ref}$) until attainment of the reference value being determined.

14. Method according to claim 11,

- in a first partial measurement with the reference element (2), the number ($N\_C_{Ref}$) of required charging processes or the time ($t_{Ref}$) until attainment of the reference value being determined,
- in a second partial measurement with the moisture sensor element (1), the number ($N\_C_S$) of required charging processes or the time ($t_S$) until attainment of the reference value being determined and,
- from the determined numbers ($N\_C_{Ref}$, $N\_C_S$) of charging processes or the times ($t_{Ref}$, $t_S$) until attainment of the reference value of charging processes and from the known capacitance ($C_{Ref}$) of the reference element (2), the capacitance ($C_S$) of the moisture reference element (1) being determined.

15. Method according to claim 14, the capacitance ($C_S$) of the moisture reference element (1) being determined according to the following relationship:

$$C_S = C_{Ref} * (N\_C_{Ref}/N\_C_S),$$

$C_S$: = capacitance of the moisture sensor element
$C_{Ref}$: = capacitance of the reference element
$N\_C_{Ref}$: = number of charging processes during partial measurement with the reference element
$N\_C_S$: = number of charging processes during partial measurement with the moisture sensor element.

16. Method according to claim 14, the reference element (2), the moisture sensor element (1) and the charge-coupled device (3) being completely discharged between the first and second partial measurement.

17. Method according to claim 14, the relative ambient humidity (rH) being determined from the capacitance ($C_S$) of the moisture sensor element (1).

18. Method according to claim 10,

- firstly both the capacitive element (1, 2) and the charge-coupled device (3) being charged via the control unit (10) with a specific charge,
- subsequently the capacitive element (1, 2) being discharged whilst the charge contained in the charge-coupled device (3) remains unchanged,
- subsequently the preceding steps being repeated enough until the charge in the charge-coupled device (3) has attained a predetermined reference value and
- the number ($N\_C_{Ref}$, $N\_C_S$) of charging processes which have been effected until attainment of the reference value or the time ($t_S$, $t_{Ref}$) until attainment of the reference value being determined, in order to determine therefrom the capacitance ($C_S$, $C_{Ref}$) of the capacitive element (1, 2).

**Revendications**

1. Circuit pour la mesure capacitive de l'humidité, qui est composé :

- d'au moins un élément capacitif (1, 2) à mesurer
- de plusieurs éléments de commutation (5a, 5b, 5c)
- d'au moins un élément accumulateur de charge (3)
- d'une unité de commande

et dans lequel l'unité de commande (10) est constituée de manière que les élément de commutation (5a, 5b, 5c) produisent une charge et une décharge de l'élément capacitif (1, 2) avec en parallèle la charge de l'élément accumulateur de charge (3) jusqu'à ce que ce dernier ait atteint une valeur de référence définie, la détection du nombre ($N\_C_{Ref}$, $N\_C_S$) des opérations de charge effectuées ou du temps ($t_S$, $t_{Ref}$) écoulé jusqu'à ce que soit atteinte la valeur de référence servant à déterminer la capacité ($C_S$, $C_{Ref}$) de l'élément capacitif (1, 2), étant précisé qu'entre l'élément accumulateur de charge (3) et l'élément capacitif (1, 2) est disposé un élément de commutation (5c) de manière qu'une décharge de l'élément accumulateur de charge (3) n'est pas possible pendant la décharge de l'élément capacitif (1, 2).

2. Circuit selon la revendication 1, qui comprend deux éléments capacitifs (1, 2) à mesurer, dont le premier est un élément de détecteur d'humidité (1) et le second un élément de référence (2), les éléments de commutation (5a, 5b, 5c) pouvant relier chaque élément (1, 2) en série avec l'élément accumulateur de charge (3) et avec l'unité de commande (10) pour déterminer la capacité.

3. Circuit selon la revendication 1, dans lequel l'élément accumulateur de charge (3) est un condensateur qui, pour déterminer la capacité, est monté en série avec l'élément capacitif (1, 2).

4. Circuit selon la revendication 3, dans lequel entre l'élément accumulateur de charge (3) et l'élément capacitif (1, 2) est monté un élément de commutation (5c) constitué par une diode.

**5.** Circuit selon au moins une des revendications précédentes, dans lequel l'unité de commande (10) est un microprocesseur qui présente, pour mesurer la capacité, une série d'entrées et de sorties (11.1 - 11.4) programmables, qui sont reliées aux éléments de commutation (5a, 5b, 5c) et à l'élément accumulateur de charge (3).

**6.** Circuit selon au moins une des revendications précédentes, dans lequel l'unité de commande (10) comprend une unité de comparaison (12) comportant deux entrées avec, sur la première entrée, une tension de comparaison (Uv) prédéfinie en tant que valeur de référence, et sur la seconde entrée une tension ($U_L$) prise sur l'élément accumulateur de charge (3), de sorte que dans le cas où la tension ($U_L$) prise sur cet élément (3) dépasse la tension de comparaison ($U_V$), l'unité de comparaison (12) délivre un signal de sortie défini.

**7.** Circuit selon la revendication 6, dans lequel l'unité de commande (10) présente de plus une unité de comptage qui saisit le nombre ($N\_C_{Ref}$, $N\_C_S$) des opérations de charge ayant abouti au dépassement de la tension de comparaison ($U_V$).

**8.** Circuit selon la revendication 2, dans lequel l'élément capacitif de référence (2) présente une capacité ($C_{Ref}$) prédéfinie.

**9.** Circuit selon la revendication 8, dans lequel l'unité de commande (10) est constituée de manière qu'à partir de nombres ($N\_C_{Ref}$, $N\_C_S$) établis par deux mesures partielles, des opérations de charge nécessaires à l'élément de référence (2) et à l'élément détecteur d'humidité (1), et de la capacité connue ($C_{Ref}$) de l'élément de référence (2), la capacité ($C_S$) de l'élément détecteur d'humidité (1) peut être déterminée et à partir de celle-ci, l'humidité ambiante (rH).

**10.** Procédé pour faire fonctionner un circuit de mesure capacitive de l'humidité, qui comprend au moins un élément capacitif (1, 2) plusieurs éléments de commutation (5a, 5b, 5c), un élément accumulateur de charge (3) ainsi qu'une unité de commande (10), selon lequel l'unité de commande (10) produit par l'intermédiaire des éléments de commutation (5a, 5b, 5c) une charge et une décharge de l'élément capacitif (1, 2) avec en parallèle la charge de l'élément accumulateur de charge (3) jusqu'à ce que ce dernier ait atteint une valeur de référence définie, la détection du nombre ($N\_C_{Ref}$, $N\_C_S$) des opérations de charge ou du temps ($t_S$, $t_{Ref}$) pour atteindre la valeur de référence et servant à déterminer la capacité ($C_S$, $C_{Ref}$) de l'élément capacitif (1, 2), étant précisé qu'entre l'élément accumulateur de charge (3) et l'élément capacitif (1, 2) est disposé un élément de commutation (5c) empêchant qu'une décharge de l'élément accumulateur de charge (3) ait lieu pendant la décharge de l'élément capacitif (1, 2).

**11.** Procédé selon la revendication 10, avec un circuit qui comprend deux éléments capacitifs (1, 2) à mesurer, dont le premier est un élément de détecteur d'humidité (1) et le second un élément de référence (2), les éléments de commutation (5a, 5b, 5c) pouvant relier au choix chaque élément (1, 2) en série avec l'élément accumulateur de charge (3) et avec l'unité de commande (10) pour déterminer la capacité.

**12.** Procédé selon au moins une des revendications précédentes, dans lequel l'unité de commande (10) est un microprocesseur qui présente, pour mesurer la capacité, une série d'entrées et de sorties (11.1 - 11.4) programmables, qui sont reliées aux éléments de commutation (5a, 5b, 5c) et à l'élément accumulateur de charge (3).

**13.** Procédé selon au moins une des revendications précédentes, dans lequel pour déterminer le nombre ($N\text{-}C_{Ref}$, $N\_C_S$) des opérations de charge ou le temps ($t_S$, $t_{Ref}$) pour atteindre la valeur de référence, une unité de commande (12) présente deux entrées avec, sur la première entrée, une tension de comparaison ($U_V$) prédéfinie en tant que valeur de référence, et sur la seconde entrée une tension ($U_L$) prise sur l'élément accumulateur de charge (3), et quand la tension ($U_L$) prise sur l'élément accumulateur (3) dépasse la tension de comparaison ($U_V$), a lieu la détection du nombre ($N\_C_{Ref}$, $N\_C_S$) des opérations de charge effectuées ou du temps ($t_S$, $t_{Ref}$) écoulé jusqu'à ce que soit atteinte la valeur de référence.

**14.** Procédé selon la revendication 11, dans lequel

- dans une première mesure partielle au moyen de l'élément de référence (2) est déterminé le nombre ($N\_C_{Ref}$) des opérations de charge nécessaires ou le temps ($t_{Ref}$) nécessaire pour que soit atteinte la valeur de référence
- dans une seconde mesure partielle au moyen de l'élément détecteur d'humidité (1) est déterminé le nombre ($N\_C_S$) des opérations de charge nécessaires ou le temps ($t_{Ref}$) nécessaire pour que soit atteinte la valeur de référence
- à partir des nombres déterminés ($N\text{-}C_{Ref}$, $N\_C_S$) des opérations de charge ou du temps ($t_{Ref}$, $t_S$) pour atteindre la valeur de référence des opérations de charge et de la capacité connue ($C_{Ref}$) de l'élément de référence (2), la capacité ($C_S$) de l'élément détecteur d'humidité est définie.

**15.** Procédé selon la revendication 14, dans lequel la capacité ($C_S$) de l'élément détecteur d'humidité (1) est défini par la règle suivante :

$$C_S = C_{Ref} * (N\text{-}C_{Ref}/N\_C_S)$$

dans laquelle

$C_S$ = capacité de l'élément détecteur d'humidité

$C_{Ref}$ = capacité de l'élément de référence

$N\_C_{Ref}$ = nombre des opérations de charge lors de la mesure partielle avec l'élément de référence

$N\_C_S$ = nombre des opérations de charge lors de la mesure partielle avec l'élément détecteur d'humidité.

**16.** Procédé selon la revendication 14, dans lequel entre la première et la seconde mesure partielle, l'élément de référence (2), l'élément détecteur d'humidité (1) et l'élément accumulateur de charge (3) sont complètement déchargés.

**17.** Procédé selon la revendication 14, dans lequel l'humidité relative ambiante (rH) est définie à partir de la capacité ($C_S$) de l'élément détecteur d'humidité.

**18.** Procédé selon la revendication 10, dans lequel

- tout d'abord, par l'unité de commande (10) à la fois l'élément capacitif (1, 2) et l'élément accumulateur de charge (3) reçoivent une charge définie
- puis l'élément capacitif (1, 2) est déchargé, la charge contenue dans l'accumulateur de charge (3) demeurant inchangée
- ensuite les étapes précédentes sont répétées jusqu'à ce que la charge dans l'élément accumulateur de charge (3) atteigne une valeur de référence prédéfinie
- le nombre ($N\text{-}C_{Ref}$, $N\_C_S$) des opérations effectuées pour atteindre la valeur de référence, ou le temps ($t_S$, $t_{Ref}$) écoulé pour atteindre cette valeur de référence, est établi pour en déduire la capacité ($C_S$, $C_{Ref}$) de l'élément capacitif.

FIG. 1

EP 1 574 847 B1

FIG. 2a

FIG. 2b

EP 1 574 847 B1

FIG. 3

**EP 1 574 847 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4103433 A1

- US 6466036 B